# EUROPÄISCHE PATENTSCHRIFT

(11) **EP 2 446 285 B1**
(45) Veröffentlichungstag und Bekanntmachung des Hinweises auf die Patenterteilung: **24.01.2018**
(21) Anmeldenummer: 10726479.8
(22) Anmeldetag: 16.06.2010
(51) Int. Cl.: G01R 31/28

(54) **VERFAHREN ZUR MESSUNG EINES LEISTUNGSBAUELEMENTS**
METHOD FOR MEASURING A POWER COMPONENT
PROCÉDÉ POUR MESURER UN COMPOSANT DE PUISSANCE

(30) Priorität: 22.06.2009 DE 102009030043
(43) Veröffentlichungstag der Anmeldung: 02.05.2012
(73) Patentinhaber: Cascade Microtech Dresden GmbH, 01561 Sacka (DE)
(72) Erfinder: HIRSCHFELD, Botho, 01108 Dresden (DE); KANEV, Stojan, 01561 Thiendorf OT Sacka (DE)
(74) Vertreter: Lippert Stachow Patentanwälte Rechtsanwälte
(86) Internationale Anmeldenummer: PCT/EP2010/058440
(87) Internationale Veröffentlichungsnummer: WO 2010/149551

(56) Entgegenhaltungen:
- EP-B1- 1 007 980
- US-A- 5 742 173
- US-A1- 2003 141 861
- US-A1- 2008 290 882

## Beschreibung

Es wird ein Verfahren offenbart zur Messung von Halbleiterbauelementen der Leistungselektronik, von Wafern mit solchen Bauelementen und leistungselektronischen Systemen, im Folgenden allgemein als Leistungsbauelement bezeichnet, in einer zur Prüfung und Testung von elektronischen Bauelementen geeigneten Messvorrichtung, welche allgemein als Prober bezeichnet wird.
Als Halbleiterbauelement der Leistungselektronik sind im Folgenden in einem Halbleiter ausgebildete elektronische Bauelement zu verstehen, die insbesondere durch eine hohe Strom- und Leistungstragfähigkeit und eine hohe Sperrfähigkeit gekennzeichnet sind. Bauelemente der Leistungselektronik sind insbesondere Bauelemente mit Schaltfunktionen, die unter hohen elektronischen und physikalischen Anforderungen und hohen Schaltfrequenzen mit steilen Spannungs- und Stromflanken zur Anwendung kommen, wie z.B. Dioden, Thyristoren, MOSFETs, IGBTs oder andere. Ein solches Leistungsbauelement oder ein Wafer, welcher eine Reihe solcher Bauelemente umfasst, sind dem Fachmann in Verbindung mit einer Messung auch als "Device Under Test - DUT" bekannt.

In einem Prober, wie in US 2008290882 A1 offenbart, wird ein Leistungsbauelement verschiedenen Messungen zu Prüfzwecken oder für Tests oder zur Ermittlung seiner Parameter unterzogen, wobei eine Messung auch unter besonderen Umgebungsbedingungen durchgeführt werden kann. Für die Messung wird das Leistungsbauelement mit einer Prüfspitze (Sonde) kontaktiert, um ein Messsignal einzuspeisen oder abzugreifen. Dazu muss eine Kontaktfläche des Leistungsbauelements und eine Sonde relativ zueinander positioniert und in Kontakt miteinander gebracht werden. Häufig werden mehrere Kontaktflächen gleichzeitig von mehreren Sonden kontaktiert. Ein Verfahrensschritt, der den Ablauf einer Messung beeinflusst, ist die Bewegung des Leistungsbauelements oder der Sonde oder beider Komponenten relativ zueinander zur Herstellung ihres Kontakts.

Die Positionierung des Leistungsbauelements und die Kontaktierung erfolgt traditionell meist mittels elektrischer Antriebe, wobei auch Nachjustierungen erforderlich sein können. Beim Anfahren der Kontaktflächen von Leistungsbauelementen besteht aufgrund der hohen Strom- oder Spannungssignale, die zur Messung dieser Bauelemente benötigt werden, die Gefahr, dass unbeabsichtigte Überschläge auftreten können. Diese können z.B. durch fehlerhafte Messprozeduren wie Zuschalten der Signaleinheit noch vor dem Kontakt oder während eines Nachjustierens verursacht werden und zu einer Schädigung des Bauelements oder der Sonde führen, möglicherweise auch einem Verschweißen der Sondenspitzen auf den Kontaktflächen. Die Gefahr des Überschlagens besteht sowohl bei automatisierten oder halbautomatischen als auch und insbesondere bei manuellen Messprozeduren, wenn die Sondenspitze im Verlauf ihrer Annäherung Kontaktfläche einen bestimmten Abstand unterschreitet.

Deshalb liegt der vorliegenden Erfindung die Aufgabe zugrunde, insbesondere auch für eine mögliche Automatisierung die Lichtbogenbildung zwischen einer Sonde und einer Kontaktfläche eines Leistungsbauelements während dessen Messung zu vermeiden und den Zeitaufwand pro Einzelmessung zu verringern und so die Messung zu effektivieren.

Mit dem erfindungsgemäßen Verfahren wird infolge einer temporären Sperrung der Signaleinheit jede Lichtbogenbildung zwischen Sonde und Kontaktfläche vermieden. Die Sperrung ist unlösbar an die Feststellung des Kontakts der Sonde auf der Kontaktfläche, d.h. an die Feststellung eines so genannten "contact mode" geknüpft und bewirkt, dass ein Messsignal während der Positionierung zwischen Sonde und Leistungsbauelement nicht anliegt.

Es ist festzuhalten, dass die Freigabe der Signaleinheit nicht lediglich an die Herstellung des Kontakts geknüpft ist, die sich bereits aus dem zeitlichen Positionierungsablauf ermitteln ließe, sondern dass vielmehr die Erfüllung der Bedingung des Kontakts aktiv ermittelt wird. Dies gewinnt insbesondere bei der Kontaktierung eines Leistungsbauelements mit mehreren Sonden gleichzeitig an Bedeutung, da entsprechend einer Ausgestaltung des Verfahrens die Freigabe der Signaleinheit erst dann erfolgt, wenn der sichere mechanische und damit auch elektrische Kontakt für jede einzelne Sonde festgestellt wurde.

Eine Freischaltung der elektrischen Verbindung zwischen der Signaleinheit und der Sonde erfolgt erst nach einer finalen Zustellbewegung, die grundsätzlich geeignet und definiert ist, den Kontakt zwischen Sonde und Leistungsbauelement herzustellen. In der Regel wird das eine Bewegung in Z-Richtung, d.h. in vertikaler Richtung sein. Je nach Form und Anordnung von Sonde und/oder Leistungsbauelement kann das aber auch eine andere Bewegung sein. Die Feststellung des "contact mode" erfolgt somit durch eine Definition des Zeitpunktes für den "contact mode" aus technischen Parametern, nämlich dem Abschluss einer Bewegung in Richtung zum Leistungsbauelement bis zum Erreichen eines Kontakts mit der Sonde. Damit ist eine Beeinflussung der Freigabe der Signaleinheit ausschließbar und technische Parameter sind nunmehr für Automatisierungszwecke nutzbar.

Darüber hinaus ist mit der Bereitstellung technischer Parameter für die Freigabe der Signaleinheit eine zeitliche Verkürzung bis zur Einspeisung oder bis zum Abgriff des Messsignals möglich, was den Durchsatz bei der Prüfung hoher Stückzahlen erhöht.

Auf welche Art die Freigabe erfolgt, kann entsprechend der Messgröße, den Umständen und Parametern der Messung, dem Leistungsbauelement oder anderen Anforderungen entsprechend angepasst werden. Grundsätzlich kann das mit mechanischen, optischen oder elektrischen Mitteln realisiert sein.

Dementsprechend kann zur Feststellung des "contact modes" z.B. die Positionierungseinrichtung konzipiert werden, mit der die relative Bewegung zwischen der einen oder mehreren Sonden und dem Leistungsbauelement zwecks Kontaktierung erfolgt, oder eine Beobachtungseinrichtung oder auch die Messeinheit selbst, die die Signaleinheit umfasst und der Steuerung der Messung dient. In letzterem Fall kann die Signaleinheit durch eine geeignete Schaltung in der Messeinheit trennbar und verbindbar sein. Mittels einer davon unabhängigen Kontaktsensoreinheit ist die Herstellung des Kontakts zwischen der Sonde und der Kontaktfläche feststellbar.

Als Kontaktsensoreinheit zur Feststellung des Kontakts können entweder die Sonden selbst oder ergänzende Referenzsonden verwendet werden, wobei letztere gemeinsam mit den Sonden positioniert und kontaktiert werden. Signale der Referenzsonden können darüber hinaus über geometrische oder zeitliche Referenzen so verarbeitet werden, dass der zum Schutz der Messanordnung erforderliche zeitliche Ablauf zwischen Feststellung des Kontakts und Freigabe der elektrischen Verbindung erzielt wird. Auch Signale von Kontaktsensoren oder Abstandssensoren können in vergleichbarer Weise zur Freigabe der elektrischen Verbindung verwendet werden.

Die Erfindung soll nachfolgend anhand verschiedener Ausführungsbeispiele näher erläutert werden. Die zugehörigen Zeichnungen zeigen in
- Fig. 1: eine Ausgestaltung eines Prober zur Messung eines Leistungsbauelements in schematischer Darstellung,
- Fig. 2: ein Diagramm zur Darstellung eines Verfahrens zur Messung eines Leistungsbauelement.

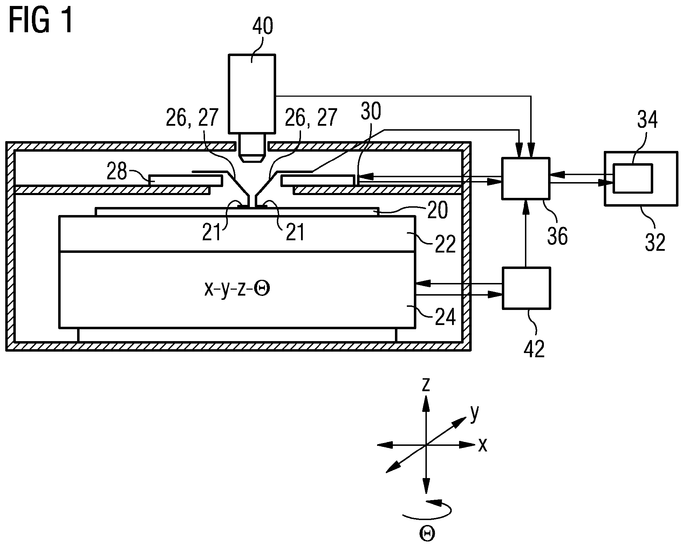

In einer Ausgestaltung eines Probers, der schematisch in Fig. 1 dargestellt ist, ist ein Leistungsbauelement 20, allgemein auch als DUT (Device Under Test) bezeichnet, auf der Aufnahmefläche eines Chucks 22 angeordnet. Der Chuck 22 weist einen X-Y-Z-Θ-Kreuztisch 24 zur Bewegung des Chucks 22 und damit des Leistungsbauelements 24 auf. Dieser Kreuztisch 24 ermöglicht eine Bewegung in beiden Richtungen einer X-Y-Ebene, welche als parallel zur Aufnahmefläche des Chucks 22 liegende Ebene definiert ist. Er ermöglicht außerdem eine Bewegung in einer senkrecht zur X-Y-Ebene stehenden Z-Richtung und eine Drehung mit einem Winkel Theta (Θ) um eine in Z-Richtung liegende Z-Achse. Die Winkelausrichtung des Chucks 22 erfolgt mittels eines Theta-Drives am Kreuztisch 24, um einen definierten Winkel Θ einer Referenzlinie oder Referenzkante des Leistungsbauelements 20 relativ zur X-oder zur Y-Richtung einzustellen. Die Ausführung der Einzelbewegungen in der X-Y-Ebene oder der Z-Richtung und die Winkelausrichtung erfolgt mit jeweils einem eigenen Antrieb, von denen einzelne oder alle elektrisch betrieben werden können.

Im Ausführungsbeispiel gemäß Fig. 1 sind eine Mehrzahl von Sonden 26 in zwei sich gegenüber liegenden Reihen, von denen jeweils nur die erste in Blickrichtung sichtbar ist, durch eine Sondenhalterung 28 gehalten. Die Anordnung der Sonden 26 korrespondiert mit der Anordnung der Kontaktflächen 21 des zu messenden Leistungsbauelements 20.

Als Sondenhalterung 28 einer oder mehrerer Sonden 26 sind in Abhängigkeit z.B. von dem Leistungsbauelement 24, von den einzuspeisenden oder abzugreifenden Testsignalen oder von den erforderlichen Bewegungsabläufen in dem Prober während einer Messung oder zwischen zwei Messungen verschiedene Sondenhalterungen 28 bekannt. Z.B. werden die Sonden 26 auf einer Sondenkarte montiert (Fig. 1), mit welcher die Ausrichtung und Fixierung der Sonden 26 zueinander und zur Anordnung der gleichzeitig zu kontaktierenden Kontaktflächen 21 des Leistungsbauelements 20 sowie die Herstellung einer elektrischen Verbindung von den Sonden 26 zu einer Schnittstelle für den Anschluss einer Messeinheit erfolgt. Solche Sondenkarten umfassen meist keine eigene Manipulatoreinheit, sie werden vor einer Messung oder Messfolge relativ zum Chuck 22 und damit zum Leistungsbauelement 20 geeignet ausgerichtet und verbleiben in dieser Position. Hier erfolgen die Bewegungen zur Positionierung und Kontaktierung während einer Messung allein durch den Chuck 22.

In einer anderen, nicht dargestellten Ausgestaltung sind die Sonden 26, einzeln oder in Gruppen zusammengefasst, an so genannten Sondenköpfen montiert. Auch die Sondenköpfe dienen der Ausrichtung, Fixierung und elektrischen Verbindung der Sonde oder Sonden 26, umfassen aber darüber hinaus eine Manipulatoreinheit, die der Bewegung des Sondenkopfs dient und manuell oder motorisch betrieben wird. Die Kombination der mit einer manuellen oder motorischen Manipulatoreinheit ausführbaren Bewegungen ist mit den Bewegungen eines Chucks 22 vergleichbar.

In verschiedenen Ausgestaltungen kann die Manipulatoreinheit einzelne oder alle der Bewegungen ausführen, die oben für den Chuck 22 beschrieben sind, wobei auch die realisierbaren Bewegungen der Manipulatoreinheit jeweils mittels eines eigenen Antriebs erfolgen. Auch diese Antriebe können selektiv oder alle elektrisch betrieben sein.

Der X-Y-Z-Θ-Kreuztisch 24 des Chucks 22 sowie eine optionale Manipulatoreinheit der Sondenhalterung 28 sind Komponenten der Positionierungseinrichtung des Probers und korrespondieren miteinander.

Über eine Schnittstelle 30, die im Ausführungsbeispiel von der Sondenhalterung 28 umfasst ist, ist jede Sonde 26, mit welcher ein Kontakt zum Leistungsbauelement 20 herzustellen ist mit einer Messeinheit 32 verbunden. Die Messeinheit 32 umfasst eine Signaleinheit 34, mit der die erforderlichen Messsignale bereitgestellt oder empfangen werden können. Die Verbindung der Signaleinheit 34 zu den Sonden 26 ist durch eine geeignete Schaltung, die nachfolgend als Interlock 36 bezeichnet werden soll, manuell und/oder automatisiert herzustellen oder zu trennen.

Im dargestellten Ausführungsbeispiel dienen als Kontaktsensoreinheit 27 alle Sonden 26, die auch der Messung des Leistungsbauelements 20 dienen. Mittels dieser Kontaktsensoreinheit 27 wird der Kontaktzustand festgestellt, indem ein kleines Hilfssignal durch alle in Reihe geschaltete Sonden geschickt wird, so dass ein den "contact mode" anzeigendes Freigabesignal erst messbar ist, wenn alle Sonden 26 auf den Kontaktflächen 21 Kontakt haben. Mit diesem Freigabesignal ist der Interlock 36 direkt oder indirekt steuerbar. Sofern kein "contact mode" oder dessen Unterbrechung festgestellt wird, wird die Signaleinheit 34 gesperrt. In einer Ausgestaltung des Verfahrens können derartige Interlock-Ereignisse angezeigt und/oder nach Wiederherstellung des "contact modes" eine automatische Freigabe oder Sperrung der Signaleinheit 34 erfolgen.

Sofern eine solche Reihenbeschaltung der Sonden 26 vom Leistungsbauelement 20 nicht unterstützt wird, sind auch andere, z.B. optische oder mechanische Methoden zur Feststellung des Kontakts und Initiierung eines Freigabe- oder Sperrsignals verwendbar.

In einer Ausgestaltung kann die Herstellung der Kontaktposition visuell festgestellt werden oder durch Bildverarbeitung mittels einer optischen Einrichtung 40 so dass eine Sperrung oder Freigabe der Signaleinheit 34 anhand optisch initiierter Signale erfolgt.

In einer weiteren Ausgestaltung wird ein Freigabesignal nach Herstellung des "contact mode" oder ein Sperrsignal zur Steuerung der Signaleinheit 34 durch die Steuereinheit 42 der Positionierungseinrichtung, im Ausführungsbeispiel die des Chucks 22 generiert, nachdem eine vordefinierte Z-Distanz zurückgelegt ist, die zur Herstellung eines sicheren Kontakts zuvor ermittelt wurde.

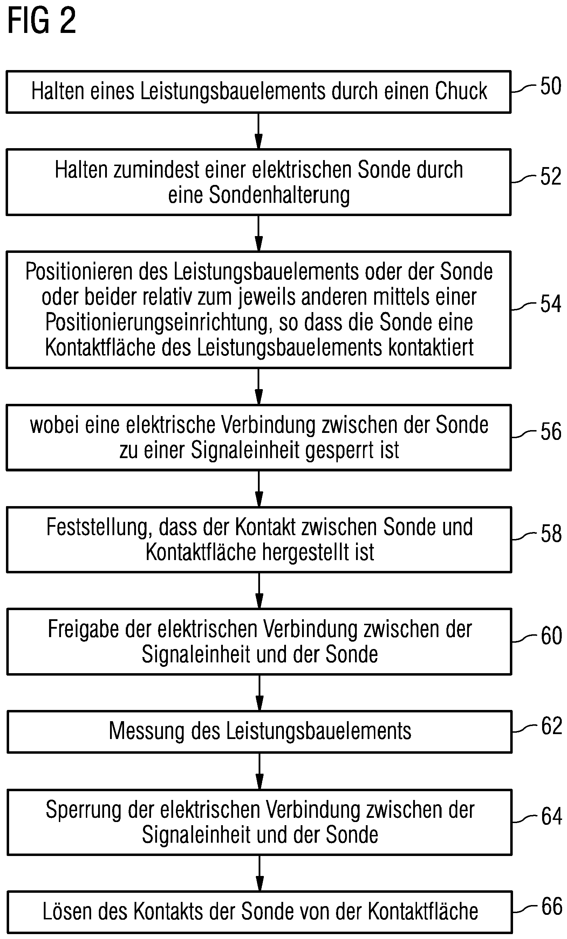

Ein Positionierungs- und Kontaktierungsvorgang als Teil einer Messung eines Leistungsbauelements 20 soll nachfolgend anhand Fig. 2 beschrieben werden. In einer ersten Ausführungsform des Verfahrens wird zunächst ein Leistungsbauelement 20 auf der Aufnahmefläche eines Chucks 22 aufgelegt und vom Chuck 22 gehalten 50.

Dem Leistungsbauelement 20 gegenüber liegend ist zumindest eine Sonde 26 angeordnet, indem sie von einer Sondenhalterung 28 gehalten ist 52.

Nachfolgend werden Leistungsbauelement 20 oder Sonde 26 oder beide mittels einer Positionierungseinrichtung relativ zueinander positioniert, so dass die Sonde 26 eine Kontaktfläche 21 des Leistungsbauelements mechanisch und elektrisch sicher kontaktiert 54. Der Ablauf zur Positionierung und Kontaktierung wird in einer Ausgestaltung des Verfahrens mittels des X-Y-Z-Θ-Kreuztisches 24 mit zwei elektrischen Antrieben zur Bewegung des Chucks 22 in der X-Y-Ebene (X-und Y-Antrieb) und mit einem elektrischen Antrieb zur Bewegung des Chucks in Z-Richtung (Z-Antrieb) realisiert. Die Beschreibung bezieht sich der besseren Übersicht wegen auf die Positionierung zur Herstellung des Kontakts zwischen einer Sonde 26 und einer Kontaktfläche 21 des Leistungsbauelements 20, erfolgt jedoch bei der gleichzeitigen Kontaktierung mehrerer Kontaktflächen 21 mittels mehrerer Sonden 26 auf die gleiche Weise, da die Anordnung der Sonden 26 an der Sondenhalterung 28 zueinander so hergestellt ist, dass sie mit der Anordnung der Kontaktflächen 21 zueinander korrespondiert.

Die Sonde 26 und das Leistungsbauelement 20 werden relativ zueinander durch Chuck 22 und Sondenhalterung 28 derart gehalten 50, 52, dass die Spitze der Sonde 26 unabhängig von ihrer Position in der X-Y-Ebene in Z-Richtung stets eine positive Distanz zur Kontaktfläche 21 des Leistungsbauelements 20 aufweist, die mittels des Z-Antriebs zu überwinden ist. Die Steuerung der drei Antriebe erfolgt mittels einer Steuereinheit 42, die Teil der Positionierungseinrichtung ist.

Ausgehend von einer Startposition wird das Leistungsbauelement 20 und damit dessen Kontaktfläche in der X-Y-Ebene mittels dieser beiden Antriebe des Chucks 22 in eine Messposition bewegt, in welcher im Unterschied zur Kontaktposition die Position der Kontaktfläche 21 in der X-Y-Ebene mit der Position der Sonde 26 in dieser Ebene übereinstimmt, jedoch mit der voreingestellten Z-Distanz. Die Bewegung in die Messposition kann sich z.B. aus mehreren Teilschritten zusammensetzen oder auch nur einen Schritt in einer Richtung umfassen. Letzteres trifft z.B. zu, wenn ein Raster von Halbleiterbauelementen auf einem Wafer abzufahren ist und das Raster auf die X- und die Y-Richtung abgestimmt ist.

Anschließend erfolgt die Zustellbewegung der Kontaktfläche 21 zur Sonde 26 in Z-Richtung bis die Spitze der Sonde 26 die Kontaktfläche 21 sicher berührt (Kontaktposition). Während des Positionierungs- und Kontaktierungsablaufs erfolgt fortlaufend eine Prüfung des Modus des Kontakts zwischen Sonde 26 und Kontaktfläche 21 des Leistungsbauelements 20, wobei die elektrische Verbindung zwischen der Sonde 26 und der Signaleinheit 34 durch den Interlock 36 gesperrt ist 56.

Sofern vor oder im Verlauf der Zustellbewegung eine Winkelabweichung zwischen der erforderlichen und der tatsächlichen Zustellbewegung z.B. aufgrund einer Abweichung von der hergestellten zur erforderlichen Messposition festgestellt wird, kann die Zustellbewegung unterbrochen oder rückgängig gemacht werden, um eine Korrektur der Messposition in der X-Y-Ebene vorzunehmen. In diesem Fall ist auch eine Nachkorrektur einer Sonde 26 in der Nähe einer Kontaktfläche 21 unproblematisch, da an der Sonde 26 infolge der getrennten Verbindung zur Signaleinheit 34 noch kein Messsignal anliegt.

Ebenso können weitere Bewegungsabläufe zur Kontaktierung des Leistungsbauelements 20 erforderlich sein, wenn mehrere Kontaktflächen 21 eines Leistungsbauelements 20 mittels mehrerer Sonden 26 kontaktiert werden. In diesen Ausgestaltungen des Verfahrens können auch mittels einer oben beschriebenen Manipulatoreinheit der Sondenhalterung 28 Bewegungen in der X-Y-Ebene und in Z-Richtung erfolgen. Z.B. kann eine Grobpositionierung des Chucks 22 mit einer Feinpositionierung der Sonden 26 ergänzt werden. In diesem Fall erfolgt die Einstellung der Messposition durch geeignete Kombination der Bewegungen des Chucks 22 und der Sonden 26 vor der Zustellbewegung zur Herstellung der Kontaktposition. Die Feststellung des Kontaktzustandes erfolgt erst, wenn alle Sondenspitzen auf der korrespondierenden Kontaktfläche 21 des Leistungsbauelements 20 aufliegen.

Mit dem Herstellen der Kontaktposition wird ein Freigabesignal generiert, welches das Erreichen des "contact mode" feststellt 58 und anzeigt, worauf der Interlock 36 der Signaleinheit 34 freigibt 60. Erst auf diese Freigabe beginnt die Messung 62 des Leistungsbauelements 20.

Indem das Ereichen des "contact mode" an die Feststellung des Kontaktes zwischen Sonde 26 und Kontaktfläche 21 und somit an messtechnisch erfassbare Parameter gekoppelt ist, ist sie von der tatsächlichen Durchführung einer Messung entkoppelt, so dass der Prober als Master fungiert und ein mit dem Prober verbundenes Messeinheit 32 als Slave.

Nach der Messung eines Leistungsbauelements 20 kann in einer weiteren Ausgestaltung des Verfahrens das nächste, z.B. das benachbarte auf einem Wafer, gemessen werden. Um den Kontakt zwischen Sonde 26 und Kontaktfläche 21 störungsfrei zu unterbrechen, wird nach Abschluss der Messung des ersten Leistungsbauelements 20 die elektrische Verbindung zwischen Signaleinheit 34 und Sonde 26 wieder gesperrt 64. Dazu wird mittels Signaleinheit 34 ein Sperrsignal generiert, worauf die elektrische Verbindung zwischen Signaleinheit 34 und Sonde 26 mittels Interlock 36 wiederum gesperrt wird. Erst danach wird der Kontakt z.B. durch Absenken des Chucks 22 gelöst 66 und ein neuer Positionierungs- und Kontaktierungsablauf kann beginnen.

## Patentansprüche

1. Verfahren zur Messung eines Leistungsbauelements (20), folgende Schritte umfassend:
- halten des Leistungsbauelements (20) durch einen Chuck (22),
- halten zumindest einer elektrischen Sonde (26) durch eine Sondenhalterung (28),
- wahlweises Positionieren des Leistungsbauelements (20) oder besagter Sonde (26) relativ zum jeweils anderen mittels einer Positionierungseinrichtung, so dass die Sonde (26) eine Kontaktfläche (21) des Leistungsbauelements (20), welche der elektrischen Kontaktierung des Leistungsbauelements (20) dient, kontaktiert,
- wobei eine elektrische Verbindung zwischen besagter Sonde (26) zu einer Signaleinheit (34), mit welcher ein Leistungssignal als Messsignal ausgesendet oder aufgenommen wird, gesperrt ist,
- Ermitteln der Erfüllung der Bedingung des Kontakts zwischen Sonde (26) und Kontaktfläche (21),
- Freigabe der elektrischen Verbindung zwischen der Signaleinheit (34) und der Sonde (26) nach der Feststellung, dass der sichere mechanische und elektrische Kontakt zwischen Sonde (26) und Kontaktfläche (21) hergestellt ist, und,
- Messung des Leistungsbauelements (20).

2. Verfahren nach Anspruch 1, wobei nach der Messung des Leistungsbauelements (20) und vor dem Lösen des Kontakts der Sonde (26) von der Kontaktfläche (21) die elektrische Verbindung zwischen der Signaleinheit (34) und der Sonde (26) erneut gesperrt wird.

3. Verfahren nach einem der vorstehenden Ansprüche, wobei bei der Herstellung des Kontakts zwischen der Sonde (26) und der Kontaktfläche (21) ein Freigabesignal generiert wird zur Freigabe der elektrischen Verbindung zwischen der Signaleinheit (34) und der Sonde (26).

4. Verfahren nach einem der Ansprüche 2 oder 3, wobei nach der Messung ein Sperrsignal generiert wird zur Sperrung der elektrischen Verbindung zwischen der Signaleinheit (34) und der Sonde (26).

5. Verfahren nach Anspruch 3 oder 4, wobei die Signaleinheit (34) Teil einer Messeinheit (32) ist und in der Messeinheit (32) das Freigabesignal und/oder das Sperrsignal generiert wird.

6. Verfahren nach Anspruch 3 oder 4, wobei die Positionierungseinrichtung eine Steuereinheit (42) umfasst und in der Steuereinheit (42) das Freigabesignal und/oder das Sperrsignal generiert wird.

7. Verfahren nach einem der vorstehenden Ansprüche, wobei die Herstellung des Kontakts zwischen der Sonde (26) und der Kontaktfläche (21) optisch ermittelt wird

8. Verfahren nach einem der vorstehenden Ansprüche, wobei die Kontaktierung des Leistungsbauelements (20) mit mehr als einer Sonde (26) erfolgt und die Freigabe der elektrischen Verbindung zwischen Signaleinheit (34) und den Sonden (26) erfolgt, wenn der Kontakt aller Sonden (26) auf der jeweils korrespondierenden Kontaktfläche (21) festgestellt wurde.

## Claims

1. Method for measuring a power component (20), comprising the following steps:
- holding the power component (20) using a chuck (22),
- holding at least one electrical probe (26) using a probe holder (28),
- selectively positioning the power component (20) or the said probe (26) relative to the respectively other element by means of a positioning device, so that the probe (26) makes contact with a contact area (21) of the power component (20), which contact area serves for making electrical contact with the power component (20),
- wherein an electrical connection between the said probe (26) and a signal unit (34), with which a power signal is emitted or received as a measurement signal, is blocked,
- ascertaining whether the condition for contact between the probe (26) and the contact area (21) has been satisfied,
- enabling the electrical connection between the signal unit (34) and the probe (26) after establishing that secure mechanical and electrical contact between the probe (26) and the contact area (21) is established, and
- measuring the power component (20).

2. Method according to Claim 1, wherein the electrical connection between the signal unit (34) and the probe (26) is once again blocked after the power component (20) is measured and before contact between the probe (26) and the contact area (21) is released.

3. Method according to either of the preceding claims, wherein an enable signal is generated for enabling the electrical connection between the signal unit (34) and the probe (26) when contact is established between the probe (26) and the contact area (21) .

4. Method according to either of Claims 2 and 3, wherein a blocking signal is generated for blocking the electrical connection between the signal unit (34) and the probe (26) after the measurement operation.

5. Method according to Claim 3 or 4, wherein the signal unit (34) is part of a measurement unit (32) and the enable signal and/or the blocking signal are/is generated in the measurement unit (32).

6. Method according to Claim 3 or 4, wherein the positioning device comprises a control unit (42) and the enable signal and/or the blocking signal are/is generated in the control unit (42).

7. Method according to one of the preceding claims, wherein the situation of contact between the probe (26) and the contact area (21) being established is visually ascertained.

8. Method according to one of the preceding claims, wherein contact is made with the power component (20) by more than one probe (26), and the electrical connection between the signal unit (34) and the probes (26) is enabled when contact by all of the probes (26) on the respectively corresponding contact area (21) has been established.

## Revendications

1. Procédé de mesure d'un composant de puissance (20), comprenant les étapes suivantes :
- maintien du composant de puissance (20) par un mandrin,
- maintien d'au moins une sonde électrique (26) par un dispositif de maintien spécial (28),
- positionnement, au choix, du composant de puissance (20) ou de ladite sonde (26) l'un par rapport à l'autre au moyen d'un dispositif de positionnement, de sorte que la sonde (26) entre en contact avec une surface de contact du composant de puissance (20) qui sert à l'établissement du contact électrique avec le composant de puissance (20),
- une liaison électrique entre ladite sonde (26) et une unité de signal (34), avec laquelle un signal de puissance faisant office de signal de mesure est envoyé ou reçu, étant bloquée,
- détermination de la réalisation de la condition de contact entre la sonde (26) et la surface de contact (21),
- libération de la liaison électrique entre l'unité de signal (34) et la sonde (26) après avoir constaté qu'un contact mécanique et électrique fiable est établi entre la sonde (26) et la surface de contact (21), et
- mesure du composant de puissance (20).

2. Procédé selon la revendication 1, la liaison électrique entre l'unité de signal (34) et la sonde (26) étant de nouveau bloquée après la mesure du composant de puissance (20) et avant de séparer le contact de la sonde (26) de la surface de contact (21).

3. Procédé selon l'une des revendications précédentes, un signal de libération étant généré lors de l'établissement du contact entre la sonde (26) et la surface de contact (21) pour la libération de la liaison électrique entre l'unité de signal (34) et la sonde (26).

4. Procédé selon l'une des revendications 2 ou 3, un signal de blocage étant généré après la mesure pour le blocage de la liaison électrique entre l'unité de signal (34) et la sonde (26).

5. Procédé selon la revendication 3 ou 4, l'unité de signal (34) faisant partie d'une unité de mesure (32) et le signal de libération et/ou le signal de blocage étant généré dans l'unité de mesure (32).

6. Procédé selon la revendication 3 ou 4, le dispositif de positionnement comprenant une unité de commande (42) et le signal de libération et/ou le signal de blocage étant généré dans l'unité de commande (42) .

7. Procédé selon l'une des revendications précédentes, l'établissement du contact entre la sonde (26) et la surface de contact (21) étant déterminée de manière optique.

8. Procédé selon l'une des revendications précédentes, le composant de puissance (20) étant mis en contact avec plusieurs sondes (26) et la libération de la liaison électrique entre l'unité de signal (34) et la sonde (26) ayant lieu lorsque le contact de toutes les sondes (26) sur la surface de contact (21) correspondance respective a été constaté.
